# EUROPEAN PATENT APPLICATION

(11) **EP 0 933 413 A2**
(43) Date of publication of application: **04.08.1999**
(21) Application number: 99100819.4
(22) Date of filing: 18.01.1999
(51) Int. Cl.: C09J 163/00, H01L 21/58, H01L 21/60, H01L 23/12

(54) **Adhesive sheets for semiconductor device and face-mounting type semiconductor device**

(30) Priority: 19.01.1998 JP 714998
(71) Applicant: NITTO DENKO CORPORATION, Osaka (JP)
(72) Inventor: Hosokawa, Kazuhito, Ibaraki-shi, Osaka (JP); Takahira, Hitoshi, Ibaraki-shi, Osaka (JP); Yoshikawa, Takao, Ibaraki-shi, Osaka (JP)
(74) Representative: Grünecker, Kinkeldey, Stockmair & Schwanhäusser Anwaltssozietät

(57) **Abstract**

An adhesive sheet for semiconductor device for fixing by adhesion a base material and a semiconductor chip or a support ring in a face-mounting type semiconductor device, wherein the glass transition temperature of the adhesive layer is 0°C or lower, the storage shear modulus at 250°C is from 1 × 10⁵ to 5 × 10⁶ dyne/cm², and the adhesive force at normal temperature is at least 50 g/cm. The adhesive sheet has a slight pressure-sensitive adhesive property at normal temperature, causing less warp of a base material and a semiconductor chip, etc., by the difference in the thermal expansion coefficients, and has a sufficient heat resistance for enduring heating in the assembling step and mounting step of a semiconductor device.

## Description

### FIELD OF THE INVENTION

The present invention relates to adhesive sheets for semiconductor device for fixing by adhering a base material and a semiconductor chip or a support ring in a face-mounting type semiconductor device and to a face-mounting type semiconductor device using the adhesive sheets.

### BACKGROUND OF THE INVENTION

Recently, with the systematization and the increase of the function of LSI, there is a tendency of increasing the number of input and output terminals, fining of pitch of a conventional edge utilization type semiconductor (edge utilization type package) cannot cope with the tendency, and a face-mounting type (face-utilization type) semiconductor device (face-utilization type package) has been developed and produced.

As the face-mounting type semiconductor device, there are BGA (Ball Grid Array), CSP (Chip Size Package) formed by reducing BGA to a chip size, etc. In the BGA, various package forms such as TBGA using a TAB (Tape Automated Bonding) tape and PBGA using a plastic base material have been considered. Furthermore, a system of mounting a bare chip with the face via an under fill material (cement), such as a flip chip has been considered.

Because in such a face-mounting type semiconductor device, face-mounting is carried out by forming bumps on the face, a semiconductor chip or a base material is warped, which causes inferior contact points and short-circuiting to greatly lower the reliability. Therefore, it is important to prevent the occurrence of the above-described warp. The warp occurs as follows. That is, a strain occurs from the difference of the thermal expansion coefficients of both members and the strain appears as the warp, which depends upon the modulus of elasticity of a cement fixing a semiconductor chip and a base material, and as the modulus of elasticity is smaller, the strain is absorbed and a warp becomes small. Accordingly, in a face-mounting type semiconductor device, it is very important to use a cement having a low modulus of elasticity.

Also, in the assembling step and the mounting step of semiconductor devices, for example, at IR (infrared) reflowing, a heat resistance of at least 200°C is necessary. The heat resistance means the heat resistance attributable to the bonding strength at the interface for preventing the foaming phenomenon caused by the expansion of a material by the evaporation of moisture absorbed in the material at heating and the heat resistance of not causing softening, flowing, deterioration, etc., of a cement itself. In regard to the foaming phenomenon, a material having a low modulus of elasticity is useful to prevent the internal stress caused by the evaporation of moisture from being concentrated and about the heat resistance of a material itself, it is desired that the material has a definite modulus of elasticity not causing softening and flowing.

In an edge utilization type semiconductor typified by conventional QFP, etc., a system which comprises sealing LSI with a sealing resin and surface-mounting onto a base material by a lead frame projected from the periphery is employed. In this case, to fix the lead frame to the base material, an adhesive tape is used. As the adhesive tape, from the necessity of ensuring the heat resistance enduring heating in the assembling step of semiconductor devices and the mounting step to a printed circuit base material, e.g., the heat treatment at the IR reflow which is carried out at a temperature of 200°C or more, and also ensuring the reliability, a thermosetting type adhesive tape which is designed to have a high modulus of expansion and a low water-absorbing property has been used.

As such a thermosetting type adhesive tape, an adhesive tape having an adhesive made up of one kind or two or more kinds of thermosetting resins such as, for example, an epoxy resin, a polyacrylonitrile resin, a polyacrylic acid ester resin, a phenol resin/nitrile rubber-based resin, a phenol resin/polyvinyl acetal-based resin, a phenol resin/epoxy resin/polyvinyl acetal-based resin, a phenol resin/epoxy resin/nitrile rubber-based resin, and a bismaleimide/cyanate ester resin-based resin as the main constituent is practically used.

However, when such an adhesive tape used for a edge-utilizing type semiconductor device is used for fixing by adhesion a base material and a semiconductor chip or a support ring (reinforcing plate) in a face-mounting type semiconductor device, because the adhesive is a material having a high modulus of elasticity, the occurrence of a warp caused by the difference in the thermal expansion coefficients cannot be prevented. The adhesive itself is excellent in the heat resistance, but a foaming phenomenon caused by the evaporation of adsorbed moisture and the concentration of stress at expansion can not be prevented, and peeling sometimes occurs. Also, because in the adhesive tapes of this kind, the glass transition temperature of the adhesive is higher than normal temperature, it is required to heat and press at adhesion, which causes a problem that the workability is bad.

Thus, the use of a liquid silicone resin as a bonding material having an excellent heat resistance and a low modulus of elasticity in place of the above-described adhesive tape has been investigated. Unlike the adhesive tape, accuracy in thickness is not obtained and handling thereof is inconvenience at applying the liquid silicone resin between a base material and a semiconductor chip or a support ring. That is, the use of the liquid silicone resin is problematic in the workability for producing semiconductor devices and the reliability, and is therefore unsuitable for the practical use.

### SUMMARY OF THE INVENTION

Under the above-described circumstances, an object of the present invention is to provide adhesive sheets which have a slight pressure-sensitive adhesive property at normal temperature, is excellent in the workability at fixing by adhesion, give less warp of a base material and a semiconductor chip by the difference in the thermal expansion coefficients, have sufficient heat resistance for enduring heating in the assembling step and the mounting step of semiconductor devices, and do not cause troubles such as foaming and peeling at heating in the above-described steps, and to provide a face-mounting type semiconductor device using the sheet.

As the result of various investigations for attaining the above-described object, the present inventors have found that in an adhesive sheet used for a face-mounting type semiconductor device, when the glass transition temperature of the adhesive layer is regulated to 0°C or lower, the adhesive sheet shows a slight pressure-sensitive adhesive property at normal temperature and thus a temporarily adhesion becomes possible, whereby the adhesive work of a base material and a semiconductor chip, etc., becomes easy, and also when the storage shear modulus at 250°C of the adhesive layer is regulated to a specific range, the adhesive tape gives less warp of the base material, the semiconductor chip, etc., by the difference of the thermal expansion coefficients and shows an excellent heat resistance such that troubles such as foaming and flowing, etc., at high-temperature heating in the assembling step and the mounting step do not occur.

That is, the first aspect of the present invention is an adhesive sheet for semiconductor device for fixing by adhesion a base material and a semiconductor chip or a support ring in a face-mounting type semiconductor device, characterized in that the glass transition temperature of the adhesive layer is 0°C or lower, the storage shear modulus at 250°C is from 1 × 10⁵ to 5 × 10⁶ dyne/cm², and the adhesive force at normal temperature is at least 50 g/cm.

The second aspect of the present invention is the adhesive sheet for semiconductor device of the first aspect, wherein the glass transition temperature of the adhesive layer is from -60 to -10°C, the storage shear modulus at 250°C is from 2 × 10⁵ to 1 × 10⁶ dyne/cm², and the adhesive force at normal temperature is from 500 to 2,000 g/cm.

Also, the third aspect of the present invention is a face-mounting type semiconductor device in which the base material and the semiconductor chip or the support ring in a face-mounting type semiconductor device are fixed by adhesion using the adhesive sheet having the construction described in the first aspect or the second aspect.

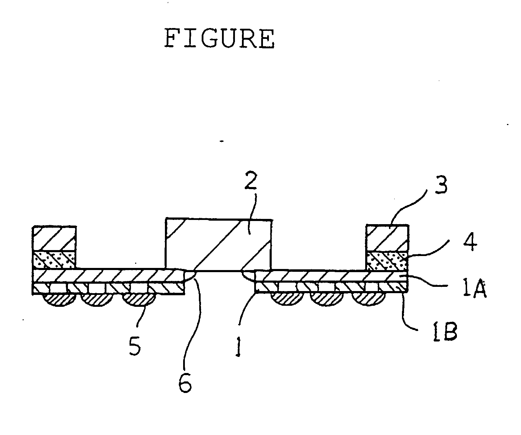

### BRIEF DESCRIPTION OF THE DRAWING

Figure is a cross-sectional view showing an embodiment of the face-mounting type semiconductor device used the adhesive sheet for a semiconductor device of the present invention.

### DETAILED DESCRIPTION OF THE INVENTION

Then, the present invention is described in detail.

The adhesive tape for a semiconductor device of the present invention has an adhesive layer in a sheet form or a tape form having a thickness of from 30 to 200 µm, and preferably from 50 to 150 µm, and the adhesive sheet may be a base material-less, double-sided adhesive sheet formed by forming the above-described adhesive layer on a releasing liner or a base material-attached adhesive sheet formed by forming the above-described adhesive layer on one surface or both surfaces, usually both surfaces of a base material. If the thickness of the adhesive layer is too thick, a good result is hard to obtain for the prevention of foaming and warping at heat stress.

As the base material, a thin base material such as a porous base material (e.g., a plastic film, a paper, a cloth and a nonwoven fabric) or a metal foil can be used. The thickness of the thin substance is generally from 25 µm to 1 mm. Films of polyimide, polyethylene terephthalate, polyethylene naphthalate, polytetrafluoroethylene, polyether ether ketone, polyether sulfone, polymethylpentene, polyether imide, polysulfone, polyphenylene sulfide, polyamide imide, polyester imide, and an aromatic polyamide are preferable as the plastic film from the point of the heat resistance.

In the present invention, the above-described adhesive layer has a slight pressure-sensitive adhesion at normal temperature, has a low modulus of elasticity and a heat resistance, and has a desired adhesive force as a bonding material, wherein the glass transition temperature is 0°C or lower, and preferably from -60 to -10°C, the storage shear modulus (at 250°C) of 1 × 10⁵ to 5 × 10⁶ dyne/cm², and preferably from 2 × 10⁵ to 1 × 10⁶ dyne/cm², and the adhesive force at normal temperature is at least 50 g/cm, and preferably from 500 to 2,000 g/cm.

The adhesive layer having such characteristics may be made up of various adhesives such as a rubber-based adhesive, an acrylic adhesive, a silicone-based adhesive, etc., but from the points of the heat resistance, the long-term stability, the economy, etc., an acrylic adhesive is preferred. For example, the acrylic adhesive can be prepared as follows. A (meth)acrylic acid alkyl ester having from 2 to 14 acrylic groups is polymerized by a solution polymerization method, an emulsion polymerization method, a suspension polymerization method, a bulk polymerization method, etc., to form an acrylic polymer. Prior to the polymerization, a monomer for modification such as acrylic acid, vinyl acetate, acrylonitrile or 2-hydroxyethyl acrylate may be added to the (meth)acrylic acid alkyl ester, if desired. A crosslinking treatment with an external crosslinking agent or an internal crosslinking agent is generally effected or a hardening resin such as an epoxy resin or a phenol resin and a hardening agent thereof are added to the acrylic polymer. As the epoxy resin, a liquid epoxy resin is preferred and a bifunctional epoxy resin is more preferred in terms of compatibility with the adhesive component such as an acrylic polymer. Thus, an acrylic adhesive can be obtained.

At the preparation of the adhesive, by appropriately controlling the monomer composition, the extent of the crosslinking treatment, the kind and the amount of the hardening resin and the hardening agent thereof, etc., the storage shear modulus at 250°C and the adhesive force at normal temperature can be easily set to the above-described ranges respectively. The adhesive thus prepared may contain various known additives such as a filler, a softening agent, a tackifier, an antioxidant, etc.

The adhesive sheet for a semiconductor device of the present invention is produced by coating an adhesive composition, obtained by adding a crosslinking agent, etc., to a previously synthesized acrylic polymer, on a releasing liner followed by drying, and in this case, applying a crosslinking treatment or a hardening treatment to form an adhesive layer having the above-described characteristics. In the case of employing a bulk polymerization such as a photopolymerization, etc., after coating the composition before carrying out the photopolymerization on a releasing liner, the coated layer is subjected to a photopolymerization treatment and at the same time a crosslinking treatment or a hardening treatment is applied thereto to form an adhesive layer having the same characteristics as described above. Also, in the case of producing the base material-attached adhesive sheet for a semiconductor device, the same procedure as described above can be carried out using the base material as described above in place of the releasing liner or the adhesive layer formed on the releasing liner as described above may be transferred onto a base material.

Figure shows an embodiment that in a face-mounting type semiconductor device wherein a semiconductor chip and a support ring (reinforcing plate) are fixed onto a base material, the support ring is fixed by adhesion on the base material via the adhesive sheet for semiconductor device of the present invention. In the figure, the numeral 1 is a semiconductor base material such as copper-stuck laminate composed of an insulating plastic layer 1A and an electrically conductive thin film 1B, 2 is a semiconductor chip fixed onto the base material 1, 3 is a support ring disposed on the peripheral portion of the base material 1, 4 is the adhesive sheet for semiconductor device of the present invention fixing by adhesion the support ring 3 onto the base material 1, and 5 is bumps for face mounting formed on the base material 1.

In such a face-mounting type semiconductor device, fixing by adhesion of the support ring 3 onto the base material 1 is, for example, carried out as follows. First, the adhesive sheet 4 for semiconductor device of the present invention formed in the ring form as the support ring 3 is stuck to the support ring 3 and the support ring 3 is temporarily fixed to the support 1 via the adhesive sheet 4. The assembly is transported to a pressing step and they are adhered by pressing, whereby the support ring 3 is strongly fixed by adhesion onto the base material 1. Since the adhesive sheet for semiconductor device of the present invention has a slight pressure-sensitive adhesive property at normal tempeerature, the above-described temporally fixing becomes possible and the occurrence of a trouble of dropping parts during the transport step is prevented, whereby the assembly work can be easily carried out.

Also, the face-mounting type semiconductor device assembled as described above, the base material 1 and the support ring 3 are less warped by the difference in the thermal expansion coefficient of them and the semiconductor device can be face-mounted onto a mother board (not shown) such as a printed circuit base material by the bumps 5 formed to the base material 1 with good reliability without causing troubles such as inferior contact points, short circuiting, etc. Furthermore, when in the face-mounting step and the assembling step, the adhesive sheet is subjected to a heat treatment of 200°C or higher at the IR reflow, etc., the adhesive sheet can sufficiently endure the heat treatment and troubles such as foaming, peeling, etc. in the interface of the adhesive do not occur.

In addition, in the above-described embodiment, fixing of the semiconductor chip onto the support is carried out by a wire bond (gold wire) 6 and fixing by adhesion of the support ring 3 onto the base material 1 is carried out using the adhesive sheet 4 for semiconductor device of the present invention. However, in other embodiment, bumps are formed to the semiconductor chip 2 and the semiconductor chip 2 may be fixed by adhere onto the base material using the adhesive sheet for 4 semiconductor device of the present invention as an under fill material in the case of face-mounting on the base material 1 by flip chip, and in this embodiment, the same effects as above are obtained.

### EXAMPLES

Then, the present invention is described more practically by the following examples. In addition, all parts in these examples, unless otherwise indicated, are by weight.

### Example 1

In a four-neck flask were placed 50 parts of isooctyl acrylate, 35 parts of n-buty acrylate, 15 parts of acrylic acid, and 0.05 part of 2,2-dimethoxy-2-phenylacetophenone and they were partially photopolymerized by irradiating with ultraviolet rays under a nitrogen gas atmosphere to provide a syrup having a viscosity of about 30 poises. Then, a photopolymerizable composition was prepared by uniformly mixing 100 parts of the syrup and 0.3 part of 1,6-hexanediol diacrylate as a crosslinking agent. The photopolymerizable composition was coated on a separator, the coated layer was photopolymerized by the irradiation of a ultraviolet ray of 900 mj/cm² to form an adhesive sheet having a thickness of 100 µm. Thus, an adhesive sheet for semiconductor device was prepared.

### Example 2

According to Example 1, an adhesive layer having a thickness of 40 µm was formed, thereafter, the adhesive layer was transferred to both surfaces of a base material made up of a polyimide film having a thickness of 25 µm to prepare an adhesive sheet for semiconductor device having total thickness of 105 µm.

### Example 3

By following the same procedure as Example 1 except that 15 parts of an epoxy resin (Epikote 828, trade name, made by Yuka Shell Epoxy Kabushikikaisha) was added to the photopolymerizable composition, an adhesive layer having a thickness of 100 µm was formed. Thus, an adhesive sheet for semiconductor device was prepared.

### Example 4

In 210 part of ethyl acetate, 90 parts of 2-ethylhexyl acrylate and 10 parts of acrylic acid were solution-polymerized using 0.4 part of 2,2'-azobisisobutyronitrile in a nitrogen gas atmosphere with stirring at a temperature of 60 to 80°C to obtain an adhesive solution having a viscosity of about 120 poises, a polymerization ratio of 99.2% by weight, and solid components of 31.4% by weight. By adding thereto 3 parts of a polyfunctional isocyanate-based crosslinking agent per 100 parts of the polymer, an adhesive solution was prepared. The adhesive solution was coated on a separator, after drying in a hot blast dryer for 5 hours at 40°C, the coated layer was further dried for 5 minutes at 130°C to form an adhesive layer having a thickness of 4.0 µm. The adhesive layer was transferred to both surfaces of a polyimide film having a thickness of 25 µm to prepare an adhesive sheet for semiconductor device having a total thickness of 105 µm.

### Comparative Example 1

An epoxy resin/nitrile rubber-based (composition ratio: 70/30 by weight) thermosetting adhesive sheet was used as an adhesive sheet for semiconductor device as comparative sample.

### Comparative Example 2

An epoxy resin/nitrile rubber-based (composition ratio: 90/10 by weight) thermosetting adhesive sheet was used as an adhesive sheet for semiconductor device as comparative sample.

About each of the adhesive sheets for semiconductor device of Examples 1 to 4 and Comparative Examples 1 and 2, a glass transition temperature, a storage shear modulus, an adhesive force, a warp, and a heat resistance were determined by the following methods. The results are shown in Table below

### Glass transition temperature and storage shear modulus

Using a viscoelastic spectral meter (RSD-11) manufactured by Leometric Co., the glass transition temperature of each adhesive layer and the storage shear modulus at 250°C were measured under the condition of a frequency of 1 Hz.

### Adhesive Force

Each adhesive sheet was stuck to a polyimide film (Ubilex 75S, made by Ube Industries, Ltd.) under a press-adhering condition: 200°C × 1 MPa × 1 second and a hardening condition: 150°C × 2 hours, and the 90 degree peel adhesive force was measured According to JIS C 2107.

### Warp

A copper-stuck laminate plate was stuck to an Si chip (5 mm × 13 mm) under a press-adhering condition: 200°C × 1 Mpa × 1 second and a hardening condition; 150°C × 2 hours, and in this case, the warp of the Si chip was measured by a surface roughness meter.

### Heat Resistance

SUS 304 was stuck to a polyimide film under a press-adhering condition; 200°C × 1 MPa × 1 second and a hardening condition: 150°C × 2 hours, and immediately after allowing to stand for 168 hours at 85°C, 60% RH, the assembly was passed through an IR reflow (peak temperature 250°C), and the presence and absence of internal foaming and a release were observed by ultrasonic inquiry. The results were evaluated as follows.
A: Neither foaming nor peeling is observed.
B: Foaming and peeling are observed.

**Table**

| | Glass Transition Temperature (°C) | Storage Shear Modulus (dyne/cm²) | Adhesive Force (g/cm) | Warp (µm) | Heat Resistance |
|---|---|---|---|---|---|
| Example 1 | -35 | 3X10⁵ | 800 | 8 | A |
| Example 2 | -35 | 3X10⁵ | 1,000 | 12 | A |
| Example 3 | -10 | 1X10⁵ | 1,800 | 15 | A |
| Example 4 | -40 | 2X10⁵ | 800 | 10 | A |
| Comparative Example 1 | 40 | 6X10⁶ | 4,800 | ≥50 | B |
| Comparative Example 2 | 80 | 8X10⁶ | 2,600 | ≥50 | B |

As is clear from the results shown in Table, it can be seen that in each of adhesive sheets for semiconductor device of Examples 1 to 4, the glass transition temperature is low as -10°C or lower, the sheet has a slight pressure-sensitive adhesive property, the storage shear modulus at 250°C is in the range of from 2 × 10⁵ to 1 × 10⁶ dyne/cm², the adhesive force is at least 800 g/cm, the occurrence of warp is less, and the sheet is excellent in the heat resistance. On the other hand, in the conventional thermosetting type adhesive sheets of Comparative Examples 1 and 2, the glass transition temperature is as high as 40°C or more, the sheet has no pressure-sensitive adhesive property, the storage shear modulus is as large as at least 6 × 10⁶ dyne/cm², a warp is large, and the heat resistance is inferior.

As described above, an adhesive sheet for semiconductor device which exhibits an excellent workability at fixing by adhesion a semiconductor base material and a semiconductor chip or a support ring, gives less warp of the base material and the semiconductor chip by the difference in the thermal expansion coefficients, does not cause troubles such as foaming and flowing at high-temperature heating in the assembling step and the mounting step and has a high reliability to a temperature cycle, and a face-mounting type semiconductor using the adhesive sheet can be provided by specifying the glass transition temperature of the adhesive layer, the storage shear modulus at 250°C, and the adhesive force at normal temperature according to the present invention.

While the invention has been described in detail and with reference to specific embodiments thereof, it will be apparent to one skilled in the art that various changes and modifications can be made therein without departing from the spirit and scope thereof.

## Claims

1. An adhesive sheet for semiconductor device for fixing by adhesion a base material and a semiconductor chip or a support ring in a face-mounting type semiconductor device, which comprises an adhesive layer having a glass transition temperature of 0°C or lower, a storage shear modulus of from 1 × 10⁵ to 5 × 10⁶ dyne/cm² at 250°C, and an adhesive force of at least 50 g/cm at normal temperature.

2. The adhesive sheet for semiconductor device of claim 1, wherein the adhesive layer has a glass transition temperature of from -60 to -10°C, a storage shear modulus of from 2 × 10⁵ to 1 × 10⁶ dyne/cm² at 250°C, and an adhesive force of from 500 to 2,000 g/cm at normal temperature.

3. A face-mounting type semiconductor device which comprises a base material and a semiconductor chip or a support ring, wherein the base material and the semiconductor chip or the support ring are fixed by adhesion using an adhesive sheet which comprises an adhesive layer having a glass transition temperature of 0°C or lower, a storage shear modulus of from 1 × 10⁵ to 5 × 10⁶ dyne/cm² at 250°C, and an adhesive force of at least 50 g/cm at normal temperature.

4. The face-mounting type semiconductor device of claim 3, wherein the adhesive layer of the adhesive sheet has a glass transition temperature of from -60 to -10°C, a storage shear modulus of from 2 × 10⁵ to 1 × 10⁶ dyne/cm² at 250°C, and an adhesive force of from 500 to 2, 000 g/cm at normal temperature.
